(19) Europäisches Patentamt
European Patent Office
Office européen des brevets

(11) **EP 1 900 194 B1**

(12) **FASCICULE DE BREVET EUROPEEN**

(45) Date de publication et mention de la délivrance du brevet:
**28.02.2018 Bulletin 2018/09**

(51) Int Cl.:
***H04N 5/3745*** (2011.01)

(21) Numéro de dépôt: **06792470.4**

(22) Date de dépôt: **29.06.2006**

(86) Numéro de dépôt international:
**PCT/EP2006/063693**

(87) Numéro de publication internationale:
**WO 2007/003577 (11.01.2007 Gazette 2007/02)**

(54) **DISPOSITIF MICROELECTRONIQUE CAPTEUR D'IMAGE A CONVERTISSEUR ANALOGIQUE/NUMERIQUE ASYNCHRONE**

MIKROELEKTRONISCHES BILDAUFNAHMEGERÄT MIT ASYNCHRONEM ANALOG-DIGITAL-WANDLER

IMAGE SENSING MICROELECTRONIC DEVICE WITH ASYNCHRONOUS ANALOG-TO-DIGITAL CONVERTER

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **01.07.2005 FR 0552007**

(43) Date de publication de la demande:
**19.03.2008 Bulletin 2008/12**

(73) Titulaire: **Commissariat à l'Énergie Atomique et aux Énergies Alternatives 75015 Paris (FR)**

(72) Inventeurs:
• **PEIZERAT, Arnaud**
  **F-38000 Grenoble (FR)**
• **ARQUES, MARC**
  **F-38100 Grenoble (FR)**

(74) Mandataire: **Ahner, Philippe et al BREVALEX 95, rue d'Amsterdam 75378 Paris Cedex 8 (FR)**

(56) Documents cités:
**US-A- 5 461 425      US-A- 6 130 713**

• **LISA G MCILRATH: "A Low-Power Low-Noise Ultrawide-Dynamic-Range CMOS Imager with Pixel-Parallel A/D Conversion", IEEE JOURNAL OF SOLID-STATE CIRCUITS, IEEE SERVICE CENTER, PISCATAWAY, NJ, USA, vol. 36, no. 5, 1 May 2001 (2001-05-01), XP011061513, ISSN: 0018-9200**

EP 1 900 194 B1

**Description**

DOMAINE TECHNIQUE

L'invention est relative au domaine des dispositifs microélectroniques imageurs ou capteurs d'image, notamment en technologie CMOS. L'invention concerne un dispositif microélectronique capteur d'image doté d'un ou plusieurs pixels, comprenant respectivement, un convertisseur analogique/numérique, et en particulier un convertisseur analogique/numérique à injection de charges amélioré, asynchrone ou dépourvu d'horloge.

L'invention concerne également un procédé amélioré de numérisation d'un signal analogique, en particulier d'un courant issu d'un détecteur appartenant à un capteur d'image. L'invention permet de mettre en oeuvre une conversion analogique-numérique, au sein de détecteurs d'un capteur d'image, avec une dynamique de conversion améliorée.

ART ANTERIEUR

Un dispositif microélectronique imageur ou capteur d'image est généralement formé d'une matrice de pixels et d'un dispositif électronique de contrôle. Chaque pixel comprend un détecteur, doté par exemple d'au moins une photodiode ou d'au moins un phototransistor, prévu (e) pour convertir l'énergie de photons incidents sur le pixel en paires électrons-trous, d'une capacité d'intégration, dont le rôle est de stocker ces charges, ainsi que d'un ou plusieurs transistors. En sortie, la matrice de pixels délivre un signal analogique, que le dispositif de contrôle est susceptible de convertir en signal numérique. La conversion analogique/numérique peut être éventuellement effectuée à l'intérieur de la puce dans laquelle la matrice de pixels est intégrée.

Le document *d'*Eric R. Fossum : « Approaches and Analysis for on Focal Plane Analog to Digital Conversion », SPIE, vol. 2226, 1994, présente plusieurs variantes de dispositifs imageurs à matrice de pixels et dispositif(s) de numérisation intégré(s) dans une même puce.

Une première variante comprend une matrice de pixels et un dispositif de conversion analogique/numérique intégrés à une même puce, le dispositif de conversion analogique/numérique étant situé en bout de la matrice.

Selon une deuxième variante, le dispositif de conversion analogique/numérique peut être situé en bout de chaque colonne de la matrice de pixels. Par rapport à la première variante, la deuxième variante permet d'obtenir une consommation plus faible de l'imageur, dans la mesure où la fréquence de fonctionnement du dispositif est divisée par le nombre de colonnes de la matrice. La deuxième variante peut également permettre de se prémunir d'un amplificateur de sortie et d'éviter ainsi le bruit qu'introduirait un tel amplificateur.

Une troisième variante met en oeuvre un dispositif de conversion analogique numérique intégré à chaque pixel de la matrice. Pour cette troisième variante, la consommation ainsi que le bruit sont diminués par rapport aux deux variantes précédentes.

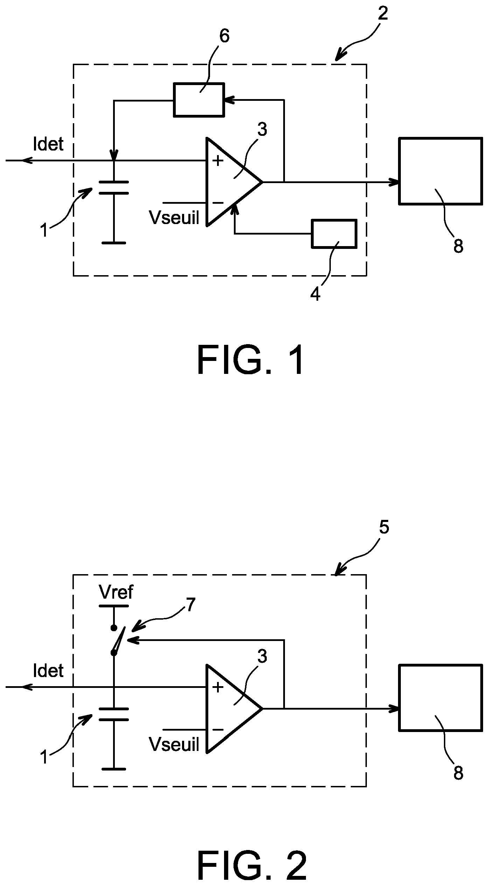

Le document US 5 461 425 divulgue un dispositif microélectronique imageur doté d'une matrice de pixels délivrant des signaux analogiques et d'une pluralité de convertisseurs analogique/numérique intégrés sur une même puce de circuit intégré que la matrice de pixels, chaque convertisseur analogique/numérique étant associé à un ou plusieurs pixels, par exemple à un groupe de 4 pixels. La figure 1 illustre un dispositif suivant l'art antérieur formé d'un détecteur associé à un convertisseur analogique numérique. Le détecteur comprend au moins un photo-détecteur. Le dispositif de numérisation est quant à lui formé d'un modulateur ΔΣ synchrone 2, comprenant un condensateur d'intégration 1 destiné à recevoir des charges, sous forme d'un courant Idet, issu du photo-détecteur, un comparateur 3 piloté par une horloge 4. Le comparateur 3 commande un injecteur de charges 6 relié à une sortie du comparateur 3 et destiné à injecter des paquets de charges dans le condensateur 1, en entrée du comparateur 3. Du modulateur ΔΣ 2 est issu un train de bits qui peut être filtré à l'aide d'un filtre numérique 8, par exemple un filtre décimateur situé à l'extérieur d'une puce dans laquelle la matrice de pixel et le dispositif de numérisation sont intégrés.

Ce type de dispositif de numérisation présente généralement une bonne linéarité, mais ne permet généralement d'atteindre qu'une résolution relativement faible.

Le document de L. G. McIlrath : « A Low Power Low-Noise Ultrawide-Dynamic Range CMOS Imager With Pixel-Parallel A/D Conversion », IEEE, JSSCC, vol. 36, n°5, Mai 2001, divulgue une variante de dispositif de numérisation intégré à un pixel d'un imageur, doté d'un modulateur ΔΣ 5 asynchrone, qui est illustré sur la figure 2. Ce modulateur ΔΣ 5 comprend un comparateur 3, qui commande un interrupteur 7 de remise à niveau à une tension de référence Vref. Du modulateur ΔΣ 5 est issu un train de bits qui peut être également transmis à un filtre numérique 8.

Un tel dispositif permet d'obtenir une très grande dynamique, par exemple de l'ordre de 15 à 17 bits. En revanche, la numérisation opérée à l'aide d'un tel dispositif est dépendante de la linéarité de la capacité et présente une linéarité insuffisante notamment lorsque le courant détecteur Idet issu du photo-détecteur est important.

Il se pose le problème de trouver un nouveau dispositif de conversion analogique-numérique intégré à un pixel d'un imageur et comportant à la fois une bonne linéarité et une bonne dynamique de conversion.

EXPOSÉ DE L'INVENTION

L'invention concerne un dispositif microélectronique comprenant les caractéristiques énoncées dans la revendication 1. Ledit dispositif microélectronique peut être un dispositif microélectronique capteur d'image ou imageur également doté d'au moins un détecteur formé d'au moins un élément photo-détecteur et comportant au moins un condensateur d'intégration, le condensateur d'intégration étant associé au photo-détecteur et apte à délivrer aux moyens de conversion analogique-numérique, au moins un signal analogique susceptible de varier au moins en fonction de quantités de photons reçues par le photo-détecteur.

Selon une possibilité de mise en oeuvre du dispositif, les quantités de charges injectées lors desdites injections de charges peuvent être égales à une quantité de charges fixe Qo.

Les moyens de conversion analogique-numérique suivant l'invention présentent une dynamique de conversion améliorée.

Les moyens de conversion analogique-numérique suivant l'invention permettent de déclencher à nouveau ou de re-déclencher le comparateur lorsque ce dernier se maintient dans un état qui n'est pas son état stable. Les moyens de conversion analogique-numérique suivant l'invention permettent d'éviter des blocages intempestifs du comparateur, notamment lorsque le détecteur délivre un courant important, par exemple supérieur à $Qo/\tau$ avec Qo une quantité de charges que les moyens injecteurs sont susceptibles de déverser et $\tau$ une constante de retard du comparateur.

Selon une première variante de mise en oeuvre, le détecteur du dispositif microélectronique suivant l'invention peut être destiné à détecter des rayonnements X.

Selon une deuxième variante de mise en oeuvre, le détecteur du dispositif microélectronique suivant l'invention peut être destiné à détecter des rayonnements infra-rouges.

Selon une possibilité, le détecteur peut appartenir à une matrice de détecteurs. Le dispositif microélectronique suivant l'invention peut comprendre une pluralité de détecteurs agencés en matrice. Selon une variante, le dispositif microélectronique suivant l'invention peut comprendre une pluralité de détecteurs agencés en matrice associés respectivement à des moyens de conversion analogique/numérique.

Selon une possibilité de mise en oeuvre, les moyens de commande sont aptes, lorsque le signal de sortie du comparateur se trouve dans le deuxième état juste après avoir été dans le premier état pendant une durée donnée, à commander un nombre de k (avec k $\geq$ 1) injections de charges jusqu'à ce que le signal (Scomp) en sortie du comparateur change d'état ou passe dans le premier état, le nombre k étant dépendant ou fonction d'une ampleur de variation du signal analogique pendant ladite durée donnée.

Selon une première variante, les moyens de commande des moyens injecteurs de charge peuvent comprendre :

- des moyens formant au moins une bascule,

- des moyens formant une ou plusieurs cellules à retard,
- des moyens formant au moins une porte logique.

Selon une possibilité, les moyens de commande des moyens injecteurs de charge peuvent comprendre un oscillateur commandé par le signal de sortie du comparateur.

Selon une variante, les moyens de commande sont aptes à commander les moyens injecteurs, par l'intermédiaire d'au moins un premier signal de phase et d'au moins un deuxième signal de phase, le premier signal de phase et le deuxième signal de phase étant des signaux à deux états.

Selon une possibilité de mise en oeuvre du dispositif microélectronique capteur d'image selon l'invention, ce dernier peut comprendre en outre : des moyens compteurs pour compter un nombre d'injections de charges effectuées par l'injecteur, à partir du premier signal de phase ou/et du deuxième signal de phase.

Selon une possibilité de mise en oeuvre du dispositif microélectronique capteur d'image, l'élément photo-détecteur et le dispositif convertisseur analogique-numérique peuvent être intégrés à un même pixel ou/et à une même puce ou/et appartenir à un même circuit intégré.

Selon une variante pour laquelle le dispositif suivant l'invention comprend des moyens compteurs, l'élément photo-détecteur, le dispositif convertisseur analogique-numérique et les moyens compteurs peuvent être intégrés à un même pixel ou/et à une même puce ou/et appartenir à un même circuit intégré.

L'invention concerne également un procédé de commande d'un dispositif convertisseur analogique/numérique intégré à un capteur d'image et associé à un détecteur formé d'au moins un élément photo-détecteur comme revendiqué dans la revendication 10. Les quantités de charges injectées lors desdites injections de charges peuvent être égales.

Selon une variante du procédé de commande, lorsque le signal de sortie du comparateur se trouve dans le deuxième état juste après avoir été dans le premier état pendant une durée donnée, le procédé peut comprendre : le déclenchement d'un nombre k, avec k $\geq$ 1 d'injections de charges jusqu'à ce que le signal à deux états change à nouveau d'état, le nombre k étant fonction, d'une ampleur de variation du signal analogique pendant ladite durée donnée.

Selon une possibilité, le procédé de commande du convertisseur analogique/numérique peut comprendre en outre : une étape de comptage du nombre d'injections de charges effectuées par l'injecteur, par l'intermédiaire d'un premier signal de phase ou/et d'un deuxième signal de phase délivrés par les moyens de commande de l'injecteur.

Selon une possibilité, l'élément photo-détecteur peut être apte à détecter un rayonnement parmi les rayonnements suivants : X ou infrarouge.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 illustre un dispositif suivant l'art antérieur, doté d'un convertisseur analogique numérique synchrone et à injection de charges, intégré à une matrice de pixels d'un imageur ou d'un capteur d'image,
- la figure 2 illustre un dispositif suivant l'art antérieur, doté d'un convertisseur analogique numérique asynchrone, intégré à une matrice de pixels d'un imageur ou d'un capteur d'image,
- la figure 3 illustre un dispositif de conversion analogique numérique asynchrone et à injection de charges suivant l'invention, intégré à une matrice de pixels d'un imageur ou d'un capteur d'image,
- la figure 4 illustre des signaux d'entrée et de sortie d'un comparateur appartenant à un dispositif de numérisation suivant l'invention disposé en sortie d'un détecteur d'un imageur, pour un courant en sortie du détecteur faible,
- la figure 5 illustre un blocage d'un comparateur, dont le convertisseur analogique/numérique suivant l'invention permet de se prémunir,
- la figure 6 illustre des signaux d'entrée et de sortie d'un comparateur appartenant à un dispositif de numérisation suivant l'invention disposé en sortie d'un détecteur d'un imageur, pour un courant en sortie du détecteur important,
- la figure 7 illustre un exemple de mise en oeuvre d'un dispositif de conversion analogique numérique suivant l'invention, intégré à au moins un pixel d'un imageur,
- la figure 8 illustre un fonctionnement en 4 phases d'un injecteur de charges appartenant à un dispositif de numérisation suivant l'invention,
- la figure 9 illustre un exemple de mise en oeuvre de moyens de commande d'un injecteur de charges, dans un dispositif de conversion analogique numérique suivant l'invention, intégré à au moins un pixel d'un imageur,
- la figure 10 représente un exemple de chronogramme d'évolution de signaux produits par des moyens de commande d'un injecteur de charge au sein d'un dispositif de numérisation suivant l'invention,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

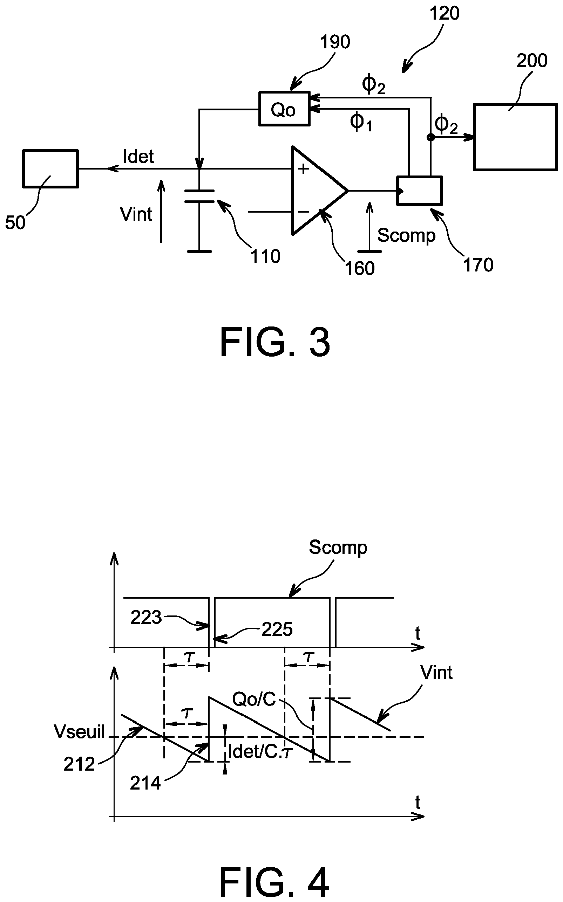

Un exemple de dispositif de numérisation ou de conversion analogique/numérique, suivant l'invention, appartenant à un dispositif microélectronique imageur ou capteur d'image, est illustré sur la figure 3.

Le dispositif de numérisation est associé à un détecteur 50 d'un pixel du dispositif capteur d'image. Le dispositif de numérisation et le détecteur peuvent être intégrés à un même pixel ou/et à une même puce ou/et à un même support ou/et peuvent appartenir à un même circuit intégré. Selon une variante, le détecteur peut être assemblé ou hybridé sur le dispositif de numérisation.

Le détecteur 50 peut comprendre au moins un élément photo-détecteur, par exemple au moins une photodiode ou au moins un phototransistor (non représenté(e) sur la figure 3), prévu(e) pour convertir l'énergie de photons incidents sur le pixel en paires électrons-trous. Selon une première variante, l'élément photo-détecteur peut être apte, à effectuer une détection de rayons X. Selon une deuxième variante, l'élément photo-détecteur peut être apte, à effectuer une détection de rayons infra-rouges. En sortie du détecteur 50, se trouve un condensateur d'intégration 110 de capacité C, destiné à recevoir des charges issues du détecteur 50 sous forme d'un courant de détection Idet. Aux bornes du condensateur 110 figure une tension ou un signal analogique noté Vint susceptible de varier, notamment en fonction du courant de détection Idet, le courant de détection Idet étant lui-même dépendant ou fonction d'une intensité lumineuse ou d'une quantité de photons reçues par le détecteur 50.

Le dispositif de numérisation comprend un modulateur $\Delta\Sigma$ 120 asynchrone ou dépourvu d'horloge de commande. Le modulateur $\Delta\Sigma$ 120 peut comprendre le condensateur 110, un comparateur 160, des moyens injecteurs 190 ou un injecteur 190 de charges, et des moyens de commande 170 ou un bloc de commande 170 de l'injecteur 190.

Le comparateur 160 est destiné à recevoir le signal analogique Vint sur une de ses entrées, et est prévu pour effectuer une comparaison de ce signal Vint avec une tension de seuil Vseuil. Le résultat de cette comparaison est produit en sortie du comparateur 160, sous forme d'un signal noté Scomp à deux états, susceptible d'adopter un premier état ou un deuxième état.

Le bloc de commande 170 de l'injecteur 190, est quant à lui disposé en sortie du comparateur 160 et destiné à recevoir en entrée le signal de sortie Scomp du comparateur 160. Le bloc de commande 170 est dépourvu d'horloge et apte à commander l'injecteur 190 au moyen d'un premier signal de phase $\Phi1$ et d'un deuxième signal de phase $\Phi2$, les signaux de phase $\Phi1$ et $\Phi2$ pouvant être également respectivement des signaux à deux états.

L'injecteur 190 de charges peut être formé de moyens interrupteurs et de moyens de stockage de charges. Les moyens de stockage de charges sont susceptibles d'emmagasiner une quantité de charge fixe Qo lorsque les moyens interrupteurs sont bloqués ou ouverts, et sont susceptibles de déverser cette quantité de charge fixe Qo lorsque les moyens interrupteurs sont passants ou fermés. L'injecteur 190 est apte à modifier le signal Vint, en déversant une charge fixe Qo ou une série de plusieurs charges fixes égales à Qo dans le condensateur 110 en entrée du comparateur 160.

Le dispositif de conversion analogique numérique, est prévu pour délivrer un signal numérique à un compteur 200. Ce signal numérique peut être par exemple le deuxième signal de phase Φ2 ou/et le premier signal de phase Φ1 de commande de l'injecteur 190. Le compteur 200 peut être prévu pour effectuer un décompte, à partir du deuxième signal de phase Φ2 ou/et du premier signal de phase Φ1, d'un nombre d'injections de charges Qo réalisé par l'injecteur 190. Ce décompte peut être effectué sur une durée donnée ou sur une période donnée. Le compteur 200 est susceptible d'incrémenter une variable de comptage à chaque injection de charge réalisée par l'injecteur 190. Le comptage du nombre d'injections de charges $Q_O$ que l'injecteur 190 a effectué, est destiné à donner une valeur numérique image des charges issues du détecteur 50. Le compteur 200, le dispositif de numérisation et le détecteur peuvent être intégrés à un même pixel ou/et à une même puce ou/et à un même support ou/et peuvent appartenir à un même circuit intégré.

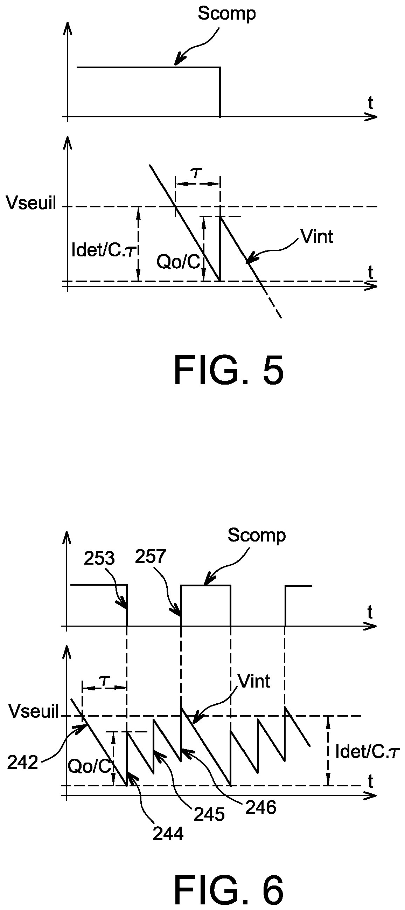

Les figures 4 et 6 illustrent le fonctionnement du dispositif de numérisation précédemment décrit, par l'intermédiaire de courbes représentatives d'évolution de signaux Vint en entrée du comparateur 160, et Scomp en sortie du comparateur 160.

Le dispositif de numérisation est susceptible d'adopter plusieurs modes de fonctionnement en fonction de l'intensité du courant détecteur Idet issue du détecteur 50.

Un premier mode de fonctionnement du dispositif de numérisation est illustré sur la figure 4, en particulier pour un courant de détection Idet appartenant à une première gamme de courants dits « faibles » ou/et tels que $I_{DET} \tau < Q_O$, avec $\tau$ une constante de retard de basculement du comparateur et Qo la quantité de charge fixe susceptible d'être déversée dans le condensateur 110 par l'injecteur 190.

Selon ce premier mode de fonctionnement, lorsque le condensateur d'intégration 110 reçoit des charges issues du détecteur 50, la tension Vint ou le signal analogique Vint varie, par exemple décroît. Une telle variation est illustrée par exemple par une portion de courbe décroissante 212 sur la figure 4. L'ampleur de cette variation ou la pente de la courbe décroissante 212, dépend de l'intensité du courant de détection Idet.

Puis, suite à cette variation, le signal analogique ou la tension Vint atteint un certain seuil, par exemple passe en dessous d'une tension de seuil notée Vseuil du comparateur 160. Un temps de retard noté $\tau$ après

l'atteinte du seuil Vseuil, le signal Scomp en sortie du comparateur 160 bascule. Lors de ce basculement, le signal Scomp en sortie du comparateur passe d'un premier état dit état « stable », par exemple un état haut, à un deuxième état, par exemple à un état bas. Un tel basculement est représenté, par exemple par un front descendant 223 sur la figure 4. Le bloc de commande 170 est alors susceptible d'effectuer une détection du basculement ou d'un passage du premier état au deuxième état du signal Scomp.

Puis, pour compenser la variation précédente du signal Vint, le bloc de commande 170 déclanche une injection de charge fixe $Q_O$ opposée à cette variation. Une telle injection de charge peut se traduire par exemple par une hausse du signal Vint (portion verticale de courbe référencée 214 sur la figure 4) d'une valeur de l'ordre de $Q_O/C$. Puis, un décompte de cette injection ou une incrémentation d'une variable de comptage suite à cette injection, est effectué par le compteur 200.

Sur la figure 4, la hausse du signal Vint provoquée par l'injection, est telle que ce signal Vint atteint une valeur supérieure à la tension de seuil du comparateur 160 et suffisante pour permettre à la sortie du comparateur de basculer à nouveau ou au signal Scomp de passer du deuxième état au premier état (front montant référencé 225) ou de repasser à l'état stable.

Suite à l'injection de charges, le bloc de commande 170 effectue une détection de l'état du signal Scomp. Le bloc de commande 170 peut alors détecter un retour à l'état stable du signal Scomp en sortie du comparateur 160. Le bloc de commande 170 effectue également, suite à cette détection de retour à l'état stable, et par l'intermédiaire des signaux de phase Φ1 et Φ2, une mise en veille de l'injecteur 190 ou une mise de l'injecteur 190 dans un état dans lequel ce dernier ne peut effectuer d'injection tant que le signal Scomp est maintenu à l'état stable ou au premier état.

Dans le premier mode de fonctionnement, le signal Scomp en sortie du comparateur 160 retrouve son état stable ou repasse dans le premier état après chaque injection de charge.

Le dispositif de conversion analogique numérique suivant l'invention peut également adopter un deuxième mode de fonctionnement pour un courant de détection Idet appartenant à une deuxième gamme de courants dits « forts » ou/et tel que $I_{DET} \tau > Q_O$.

La numérisation, mise en oeuvre par le convertisseur suivant l'invention, est peu sensible ou insensible à la rapidité du comparateur 120 ou au retard $\tau$ de déclenchement du comparateur 120, et permet, contrairement aux dispositifs suivant l'art antérieur, de se prémunir d'un blocage tel qu'illustré sur la figure 5, d'un signal de sortie Scomp d'un comparateur, lorsque le courant $I_{DET}$ en sortie du détecteur est tel que $I_{DET} \tau > Q_O$.

La figure 6 illustre en particulier le deuxième mode de fonctionnement du dispositif de conversion analogique, pour des courants de détection tels que $I_{DET} \tau > Q_O$.

De même que pour le premier mode de fonctionnement, lorsque le condensateur d'intégration 110 reçoit des charges issues du détecteur 50, la tension Vint ou le signal analogique Vint varie, par exemple décroît. Une telle variation est illustré par exemple par une portion de courbe décroissante 242 sur la figure 6.

Puis, suite à cette variation, quand le signal analogique ou la tension Vint atteint un certain seuil, par exemple passe en dessous d'une tension de seuil Vseuil du comparateur 160, la sortie de ce dernier bascule après un retard noté $\tau$. Lors de ce basculement, le signal Scomp en sortie du comparateur passe du premier état dit état « stable », par exemple l'état haut, au deuxième état, par exemple l'état bas. Un tel basculement est représenté par exemple par un front descendant 253 sur la figure 6.

Le bloc de commande 170 met en oeuvre une détection du basculement ou du passage du premier état au deuxième état du signal Scomp. Puis, pour compenser la variation du signal Vint, le bloc de commande 170 déclenche une première injection de charge par les moyens 190, ces derniers déversant dans la capacité d'intégration 110, une charge fixe $Q_0$ opposée à la précédente variation de Vint.

La première injection de charge se traduit par une hausse (portion de courbe référencée 244) du signal Vint d'une valeur de l'ordre de $Q_0/C$. Sur la figure 6, suite à la première injection, le signal Vint n'atteint pas une valeur supérieure à la tension de seuil du comparateur 160, ou nécessaire pour permettre de déclencher à nouveau le comparateur 160 ou pour permettre au signal Scomp de changer d'état et par exemple de retrouver le premier état ou l'état stable. Suite à la première injection, le signal Scomp se maintient dans le deuxième état.

Après la première injection, le bloc de commande 170 réalise une détection de l'état du signal Scomp. Le bloc de commande 170 peut alors détecter le maintien du signal Scomp au deuxième état, et déclencher, suite à cette détection et par l'intermédiaire des signaux de phase Φ1 et Φ2, une deuxième injection (portion verticale référencée 245) de quantité de charges $Q_0$ par l'injecteur 190.

Suite à la deuxième injection de charges Qo, le signal Vint n'atteint toujours pas une valeur supérieure à la tension de seuil, ou nécessaire pour permettre de déclencher à nouveau le comparateur 160. Le signal Scomp se maintient dans le deuxième état suite à la deuxième injection.

Le bloc de commande 170 peut alors mettre en oeuvre une nouvelle détection de l'état du signal Scomp après cette deuxième injection.

Suite à cette nouvelle détection, et par l'intermédiaire des signaux de phase Φ1 et Φ2, il déclenche une troisième injection (portion verticale référencée 246) de quantité de charges $Q_0$ par l'injecteur 190.

Cette troisième injection de charges provoque une nouvelle hausse du signal Vint d'une valeur de l'ordre de $Q_0/C$. Suite à cette nouvelle hausse, le signal Vint atteint une valeur supérieure à la tension de seuil et suffisante pour permettre de déclencher à nouveau le comparateur 160 ou pour permettre au signal Scomp de changer d'état (front montant référencé 257) et par exemple de retrouver le premier état ou l'état stable. Le bloc de commande 170 est ensuite susceptible de mettre en oeuvre une détection de l'état du signal Scomp. Le bloc de commande 170 peut détecter le passage au premier état ou du retour à l'état stable du signal Scomp. Le bloc de commande 170 peut également déclencher, suite à cette détection, et par l'intermédiaire des signaux de phase Φ1 et Φ2, une mise en veille de l'injecteur 190 ou une mise de l'injecteur 190 dans un état dans lequel ce dernier ne peut effectuer d'injection tant que le signal Scomp est maintenu à l'état stable.

Dans ce deuxième mode de fonctionnement, le bloc 170 est apte à déclencher plusieurs injections de charges tant que le signal Scomp en sortie du comparateur se trouve dans le deuxième état et n'a pas retrouvé son état stable.

Les blocs ou les moyens de commande 170 sont aptes à déclencher, en fonction du signal à deux états Scomp, plusieurs injections de charges Q entre au moins deux changements d'états successifs du signal Scomp, du premier état au deuxième état et du deuxième état au premier état.

Un modulateur ΔΣ 120 apte à re-déclencher ou à déclencher à nouveau le comparateur 160, lorsque ce dernier reçoit en entrée des variations importantes de courant de détection Idet ou des valeurs de courant de détection Idet importantes, est ainsi mis en oeuvre.

Un tel dispositif de conversion analogique-numérique, permet de numériser des courants de détection $I_{DET}$ tels que $I_{DET}\tau > Q_0$ et est ainsi doté d'une dynamique améliorée. Un tel dispositif de conversion analogique-numérique est également doté d'une robustesse améliorée vis-à-vis de brusques variations du signal analogique Vint aux bornes du condensateur d'intégration 110.

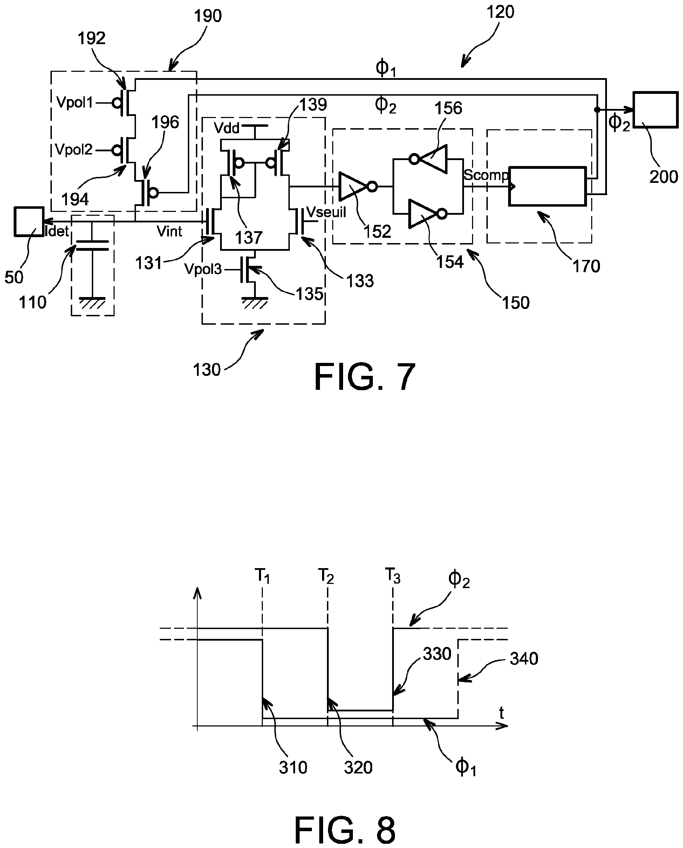

La figure 7 montre un exemple de mise en oeuvre du dispositif de numérisation suivant l'invention, précédemment décrit.

Le modulateur ΔΣ 120 peut être réalisé en technologie CMOS (CMOS pour « Complemetary Metal Oxide Semi-conductor » ou « semi-conducteur à oxyde de métal complémentaire) et comprend un comparateur 160, formé d'un amplificateur différentiel 130 et d'un circuit à déclenchement 150, communément appelé circuit « trigger », situé en sortie de l'amplificateur différentiel 130.

L'amplificateur différentiel 130 peut être formé par exemple de 5 transistors 131, 133, 135, 137, 139. Un premier transistor 131, par exemple de type NMOS, et un deuxième transistor 133, par exemple de type NMOS, forment une paire différentielle, et ont une électrode de source commune. Le premier transistor 131 situé en entrée de l'amplificateur différentiel 130 est relié au condensateur d'intégration 110, et reçoit le signal analogique Vint sur sa grille, tandis que la grille du deuxième transistor 133 est mise à un potentiel Vseuil, définissant la tension de basculement du comparateur 160. L'électrode de source commune au premier transistor NMOS 131 et au deuxième transistor NMOS 133 est également reliée au drain d'un troisième transistor NMOS 135, dont la grille est quant à elle mise à un potentiel fixe Vpol3. L'amplificateur différentiel 130 comprend également un quatrième transistor 137, par exemple de type PMOS et un cinquième transistor 139, par exemple de type PMOS. Le quatrième transistor 137 et le cinquième transistor 139 sont agencés ou montés en miroir de courant. Le quatrième transistor 137 et le cinquième transistor 139 partagent également une région de source commune, mise à un potentiel fixe Vdd. Les électrodes de drain du quatrième transistor 137 et du cinquième transistor 139 sont quant à elles reliées respectivement à l'électrode de drain du premier transistor 131 et à l'électrode de drain du deuxième transistor 133. Le quatrième transistor 137 possède également une électrode de grille et une électrode de drain reliées entre elles.

La sortie de l'amplificateur 130 différentiel, peut être prise au niveau de l'électrode de drain du cinquième transistor 139 et de l'électrode de drain du deuxième transistor 133. La sortie de l'amplificateur 130 est reliée à une entrée du circuit à déclenchement 150. Ce circuit à déclenchement 150 peut être formé par exemple de trois inverseurs 152, 154, 156. Un premier inverseur 152 est relié à la sortie de l'amplificateur différentiel 130, et mis en série avec un ensemble de deux autres inverseurs 154, 156. Les deux autres inverseurs 154 et 156 sont disposés en parallèle, et de sorte que la sortie de l'un des deux inverseurs 154 et 156, est reliée à la sortie de l'autre des deux inverseurs 154 et 156. Le circuit de déclenchement 150 délivre en sortie le signal Scomp numérique ou à deux états.

Dans cet exemple de mise en oeuvre, les moyens injecteurs de charge 190 peuvent être quant à eux formés de transistors 192, 194, 196, pilotés ou commandés par les signaux $\Phi 1$ et $\Phi 2$ à deux états issus du bloc de commande 170. Les moyens injecteurs de charge 190 peuvent comprendre notamment un premier transistor 192, de type PMOS, dont la source est reliée à la première sortie du bloc 170 délivrant le signal $\Phi 1$ et dont la grille est mise à un potentiel de polarisation fixe Vpol1. Les moyens injecteurs de charge 190 peuvent comprendre également un deuxième transistor 194, en série avec le premier transistor 192, et dont la source est reliée au drain du premier transistor 192. La grille du deuxième transistor 194 est mise à un potentiel fixe vpol2, inférieur au potentiel vpol1.

Le premier transistor 192 et le deuxième transistor 194 sont commandés par le premier signal de phase signal $\Phi 1$ et peuvent former les moyens de stockage de charge fixe $Q_0$ pour l'injecteur 190. L'injecteur de charge 190 comprend également un troisième transistor 196, dont la grille est reliée à la deuxième sortie du bloc de commande 170 délivrant le signal $\Phi 2$, et dont le drain est relié à la première électrode du condensateur d'intégration 110. Le troisième transistor 196 commandé par

le signal $\Phi 2$ peut former les moyens interrupteurs de l'injecteur de charge 190.

Cet injecteur de charges 190 peut avoir un fonctionnement cyclique et est susceptible d'adopter, à tour de rôle, différentes états ou différentes phases de fonctionnement, par exemple 4 phases de fonctionnements.

La figure 8 illustre, par l'intermédiaire d'un chronogramme, les phases d'un cycle de fonctionnement de l'injecteur de charges 190, en fonction d'un exemple d'évolution des états respectifs des signaux de phase $\Phi 1$ et $\Phi 2$ délivrés par le bloc de commande 170.

Dans un premier intervalle de temps du chronogramme, jusqu'à un instant $T_1$, l'injecteur de charges 190 se trouve dans une première phase de fonctionnement, dite phase « de remplissage ». Durant cette première phase, le deuxième signal de phase $\Phi 2$ est mis dans un premier état, par exemple un état haut, permettant de maintenir ouvert les moyens interrupteurs (par exemple sous forme d'un transistor 196 illustré sur la figure 8) de l'injecteur 190. Durant la première phase, le premier signal de phase $\Phi 1$ est quant à lui mis dans un premier état, par exemple un état haut, permettant aux moyens de stockage de charge (par exemple sous forme des transistors 192, 194 illustrés sur la figure 8) d'emmagasiner une certaine quantité des charges.

Puis, à l'instant T1, le premier signal de phase $\Phi 1$ change d'état (front descendant référencé 310) et passe dans un deuxième état, par exemple à un état bas. Ce changement d'état du signal $\Phi 1$ provoque une entrée de l'injecteur 190 dans une deuxième phase de fonctionnement. Durant un deuxième intervalle de temps ]T1 ; T2[, l'injecteur de charges 190 se trouve dans la deuxième phase de fonctionnement, dite phase « d'écrémage ». Pendant cette deuxième phase, le signal $\Phi 2$ est maintenu dans le premier état, ce qui permet de maintenir ouvert l'interrupteur de l'injecteur de charges 190. Le signal $\Phi 1$ est mis, quant à lui, dans un deuxième état, par exemple à l'état bas, pour lequel les moyens de stockage de charge ne conservent qu'une portion ou qu'une quantité de charges fixe Q0, de la certaine quantité de charges emmagasinée durant la première phase.

Ensuite, à un instant T2, le deuxième signal de phase $\Phi 2$ change d'état (front descendant référencé 320), et passe par exemple à un état bas. Ce changement d'état du signal $\Phi 2$ provoque une entrée de l'injecteur 190 dans une troisième phase de fonctionnement. Durant un troisième intervalle de temps ]T2 ; T3[, l'injecteur de charges 190 est placé dans la troisième phase de fonctionnement, dite phase « de transfert de charges ». Durant cette troisième phase, le signal $\Phi 1$ est maintenu dans le deuxième état, par exemple l'état bas, pour lequel les moyens de stockage de charge sont aptes à déverser la quantité de charge fixe Q0. Le signal $\Phi 2$ est quant à lui mis dans un deuxième état, par exemple à l'état bas, susceptible de maintenir fermé l'interrupteur de l'injecteur 190 (sous forme du transistor 196), et de permettre de déverser la quantité de charges fixe Q0 dans le condensateur d'intégration 110.

Puis, à un instant T3, le deuxième signal de phase Φ2 change d'état, et passe (front référencé 330) par exemple au premier état, par exemple à l'état haut. Ce changement d'état du signal Φ2 provoque une entrée de l'injecteur 190 dans une quatrième phase de fonctionnement. Durant un quatrième intervalle de temps ]T3 ; T4[, l'injecteur de charges 190 se trouve dans la quatrième phase de fonctionnement, dite phase « d'isolation du condensateur d'intégration ». Le signal Φ2 est mis dans un état, permettant de maintenir ouvert l'interrupteur (sous forme du transistor 196) de l'injecteur 190 et d'isoler les moyens de stockage de charge du condensateur d'intégration 110.

Ensuite, le premier signal de phase Φ1 change à nouveau d'état (front référencé 340), et passe par exemple au premier état, par exemple à l'état haut. Ce nouveau changement d'état du signal Φ1 engage l'injecteur 190 dans un nouveau cycle.

Les quatre phases de fonctionnement de l'injecteur 190 peuvent avoir des durées respectives différentes les unes par rapport aux autres.

D'une phase d'écrémage à une autre phase d'écrémage du fonctionnement cyclique de l'injecteur 190, la quantité de charge emmagasinée Q0 par l'injecteur de charge 190 est de préférence la même ou sensiblement la même. Autrement dit, les quantités de charges emmagasinées par les moyens de stockage de charge 192 et 194 lors des différentes phases d'écrémage de l'injecteur 190, sont de préférence égales entre elles ou sensiblement égales entre elles et à Q0.

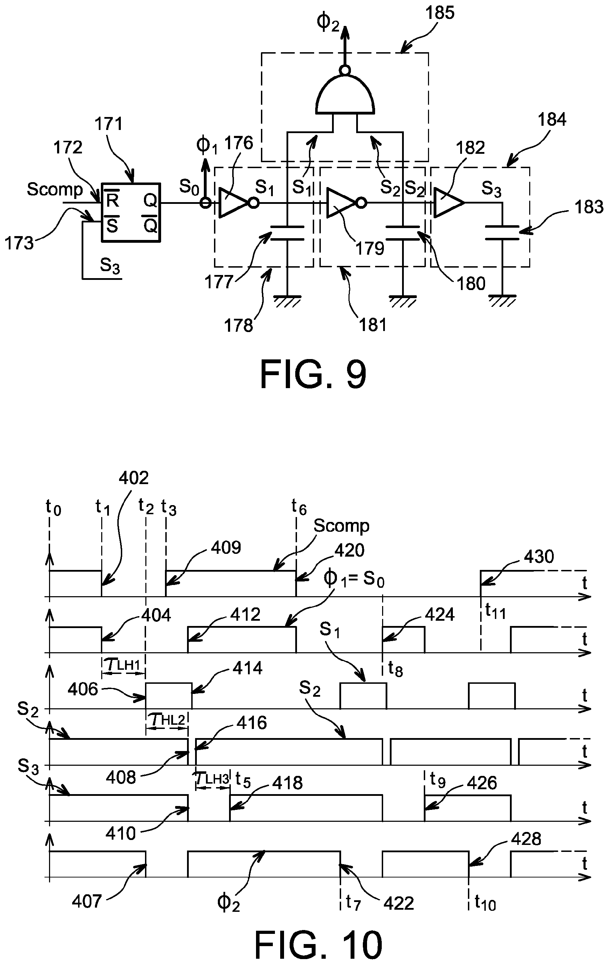

Un exemple détaillé de mise en oeuvre du bloc de commande 170 est illustré sur la figure 9. Le bloc 170 est dépourvu d'horloge et/ou a un fonctionnement asynchrone. Le bloc 170 comporte tout d'abord dans cet exemple, une bascule 171 de type bascule RS, qui peut être formée par exemple d'une première et d'une deuxième portes NAND (non représentées). La bascule 171 comporte une première entrée 172 et une deuxième entrée 173. La première entrée 172 dite entrée « reset » ou « R », correspond à une entrée de la deuxième porte NAND et est destinée à recevoir le signal Scomp de sortie du comparateur 160. La deuxième entrée 173 de la bascule 171, dite entrée « set » ou « S », correspond quant à elle, à une entrée de la première porte NAND, et est destinée à recevoir un signal S3, dépendant ou fonction d'un signal S0 émis sur une première sortie 174 de la bascule 171.

La première sortie 174 de la bascule 171, correspond à la sortie de la première porte NAND, ou a une sortie communément appelée « Q » de la bascule 171. La première sortie 174 de la bascule 171 est reliée à une succession de cellules 178, 181, 184 dites « à retard », disposées en série.

Parmi les cellules à retard 178, 181, 184, figure une première cellule 178, reliée à la sortie 174 de la bascule 171. La première cellule 178 reçoit le signal S0 en sortie 174 de bascule 171 et délivre un signal S1 en entrée d'une deuxième cellule 181.

La première cellule 178, peut être par exemple prévue pour, suite à la réception d'un front descendant du signal S0 en sortie de la bascule 171, transmettre en sortie un front montant, avec un délai $\tau_{LH1}$. La première cellule 178, peut être également prévue pour, suite à la réception d'un front montant du signal S0 en sortie de la bascule 171, transmettre en sortie un front descendant avec un délai de transfert $\tau_{HL1}$ différent de $\tau_{LH1}$. Les délais de transferts $\tau_{HL1}$ et $\tau_{LH1}$ peuvent être ajustés de sorte que $\tau_{LH1}$ est supérieur à ou très supérieur à $\tau_{HL1}$. Le délai $\tau_{LH1}$ peut être par exemple au moins dix fois plus élevé ou au moins cent fois plus élevé que le délai $\tau_{HL1}$. La première cellule 178 peut être formée par exemple d'un inverseur 176 et d'un condensateur 177.

La deuxième cellule 181, en sortie de la première cellule 178, est apte à délivrer un signal S2 à une troisième cellule 184. La deuxième cellule 181, peut être par exemple prévue pour, suite à la réception d'un front descendant du signal S1 en sortie de la première cellule 178, transmettre en sortie un front montant avec un délai $\tau_{LH2}$. La deuxième cellule 181, peut être également prévue pour, suite à la réception d'un front montant du signal S1 en sortie de la première cellule 177, transmettre en sortie un front descendant avec un délai de transfert $\tau_{HL2}$ différent de $\tau_{LH2}$. La deuxième cellule 181 peut être mise en oeuvre, de sorte que $\tau_{HL2}$ est supérieur à, ou très supérieur à $\tau_{LH2}$. Le délai $\tau_{LH2}$ peut être par exemple au moins dix fois plus élevé ou au moins cent fois plus élevé que le délai $\tau_{LH2}$. La deuxième cellule 181 peut être formée par exemple d'un inverseur 179 et d'un condensateur 180.

La troisième cellule 184, en série avec la deuxième cellule 181, est apte à délivrer le signal S3. La troisième cellule 184 est reliée à l'entrée 173 « set » ou « S » de la bascule 171 et permet de délivrer le signal S3 sur cette entrée 173.

Le signal S3 est susceptible d'indiquer la fin d'un cycle de fonctionnement de l'injecteur.

La troisième cellule 184, peut être par exemple prévue pour transmettre avec un délai de transfert $\tau_{HL3}$, un front descendant du signal S2 en sortie de la deuxième cellule 181. La troisième cellule 184 peut être également prévue pour transmettre avec un délai de transfert $\tau_{LH3}$ différent de $\tau_{HL3}$, un front montant du signal S2 en sortie de la deuxième cellule 181. Les délais de transferts $\tau_{HL3}$ et $\tau_{LH3}$ peuvent être ajustés de sorte que $\tau_{LH3}$ est supérieur à $\tau_{HL3}$ ou est très supérieur à $\tau_{HL3}$. Le délai $\tau_{LH3}$ peut être par exemple au moins dix fois plus élevé ou au moins cent fois plus élevé que le délai $\tau_{HL3}$. La troisième cellule 184 peut être formée par exemple d'un suiveur 182 et d'un condensateur 183.

Le signal S0 en sortie de la bascule 171 est également émis en sortie du bloc de commande 170 et correspond ou est égal au premier signal de phase Φ1, de commande des moyens de stockage de charge de l'injecteur 190. Les sorties de la première cellule 178 et de la deuxième cellule 181, sont quant à elles reliées à un bloc 185, réalisant une fonction logique par exemple un fonction NAND ou « non-et » entre le signal S1 et le signal S2. Le bloc 185 émet un signal $\overline{S1 \cdot S2}$ égal ou correspondant au deuxième signal de phase Φ2 de commande de l'injecteur 190, et en particulier de l'interrupteur de cet injecteur.

Les délais de transferts $\tau_{LH1}$, $\tau_{LH2}$, $\tau_{LH3}$, $\tau_{HL1}$, $\tau_{HL2}$, $\tau_{HL3}$ des cellules 178, 181, 184, sont ajustés en fonction des durées respectives des phases de fonctionnement de l'injecteur 190 décrites précédemment, que l'on souhaite obtenir.

Plusieurs délais parmi les délais de transferts $\tau_{LH1}$, $\tau_{LH2}$, $\tau_{LH3}$, $\tau_{HL1}$, $\tau_{HL2}$, $\tau_{HL3}$, des cellules 178, 181, 184, peuvent être ajustés en fonction d'une durée, correspondant à une durée cumulée notée $\tau_1$ de la première phase de fonctionnement, de la deuxième phase de fonctionnement, et de la troisième phase de fonctionnement de l'injecteur 190, ou à une durée pendant laquelle le premier signal de phase Φ1 est mis dans le deuxième état, par exemple à l'état bas. La durée cumulée $\tau_1$ de la première phase de fonctionnement, de la deuxième phase de fonctionnement, et de la troisième phase de fonctionnement de l'injecteur 190, peut être par exemple telle que :

$$\tau_1 \approx \tau_{LH1} + \tau_{LH2} + \tau_{HL3}.$$

Plusieurs délais parmi les délais de transferts $\tau_{LH1}$, $\tau_{LH2}$, $\tau_{LH3}$, $\tau_{HL1}$, $\tau_{HL2}$, $\tau_{HL3}$, des cellules 178, 181, 184, peuvent être ajustés en fonction d'une durée $\tau_2$, correspondant à la durée de la troisième phase de fonctionnement de l'injecteur 190 ou phase de transfert de charges, ou à une durée pendant laquelle le deuxième signal de phase Φ2 est mis dans le deuxième état, par exemple à l'état bas. La durée $\tau_2$ peut être par exemple telle que : $\tau_2 \approx \tau_{HL2} + \tau_{HL3}$. $\tau_{LH3}$ peut correspondre à la durée de réinitialisation des potentiels ou des signaux du bloc de commande 170.

La figure 10 illustre un fonctionnement du bloc de commande 170 décrit plus haut, par l'intermédiaire d'un exemple de chronogramme d'évolution des signaux S0, S1, S2, S3, produits à l'intérieur de ce bloc de commande 170, et des signaux Φ1=S0, $\Phi2 = \overline{S1 \cdot S2}$, délivrés en sortie du bloc de commande 170 (décrit précédemment en liaison avec la figure 9), en fonction de l'évolution du signal Scomp en sortie du comparateur 160.

Comme cela a été décrit plus haut, le signal Scomp peut être un signal à deux états, susceptible d'adopter un premier état dit « état stable » ou un deuxième état, en fonction des variations du signal analogique Vint (non représenté sur cette figure).

Entre un instant t0 et un instant t1 sur le chronogramme, le signal Scomp se trouve dans le premier état ou « état stable », par exemple à l'état haut.

Puis, à un instant t1, le signal Scomp en sortie du comparateur 160 change d'état et passe (front descendant référencé 402 sur la figure 10) dans un deuxième état, par exemple un état bas.

Le bloc de commande 170 effectue une détection de ce changement d'état.

Ce changement d'état se traduit par un front de commande qui se propage à travers la bascule 171 et entraîne un changement d'état du premier signal de phase Φ1=S0, ce dernier passant par exemple à un état bas (front descendant référencé 404). Le passage du premier signal de phase Φ1 à l'état bas provoque une entrée de l'injecteur 190 dans sa deuxième phase de fonctionnement ou phase « d'écrémage » décrite plus haut.

Le passage du premier signal de phase Φ1 à l'état bas, entraîne également, après le délai $\tau_{LH1}$, un passage à l'état haut (front montant référencé 406) du signal S1 et un passage à l'état bas (front descendant référencé 407) du signal Φ2. Ce changement d'état du signal Φ2, provoque une entrée de l'injecteur 190 dans sa troisième phase de fonctionnement, autrement dit provoque une première injection de charge à l'instant t2 ou à partir de l'instant t2.

Cette première injection de charge modifie le signal analogique Vint en entrée du comparateur 160 et par exemple provoque une hausse du signal Vint. Comme l'indique un front montant référencé 409 a un instant t3, cette hausse du signal analogique Vint provoque un changement d'état du signal Scomp en sortie du comparateur 160, et permet au signal Scomp de revenir au premier état ou dans un état « stable ».

Le front de commande se propage quant à lui jusqu'en sortie de la deuxième cellule 181. Ainsi, le passage à l'état haut (front référencé 406) du signal S1 entraîne, après un certain délai $\tau_{HL2}$, un passage à l'état bas (front descendant référencé 408 sur la figure 10) du signal S2 et un changement d'état du signal Φ2. Ce changement d'état du signal Φ2, provoque une entrée de l'injecteur 190 dans sa quatrième phase de fonctionnement.

Le front de commande se propage ensuite jusqu'en sortie de la troisième cellule 184. Ainsi, le passage à l'état bas (front référencé 408) du signal S2, provoque, après un certain délai $\tau_{HL3}$ (non référencé sur la figure 10), un passage à l'état bas (front descendant référencé 410 sur la figure 10) du signal S3.

Le délai $\tau_{HL3}$ peut être choisi inférieur ou très inférieur ou négligeable par rapport aux délais $\tau_{LH1}$ et $\tau_{HL2}$.

Le signal S3 en sortie de la troisième cellule 184 est ensuite réémis en entrée du bloc 170, et en particulier à l'entrée 173 « set » ou « S » de la bascule 171.

Après la première injection de charges, le bloc de commande 170 met en oeuvre au moins une détection de l'état du signal Scomp en sortie du comparateur 160.

Ce signal Scomp étant revenu à l'état stable ou au premier état après la première injection de charge, le signal S0 en sortie de bascule 171 change d'état (front montant référencé 412), ce qui provoque un retour de l'injecteur 190 dans sa première phase de fonctionnement.

Le passage à l'état haut du signal S0 provoque, après le délai $\tau_{HL1}$ (non référencé sur la figure 10), un passage à l'état bas (front descendant référencé 414 sur la figure 10) du signal S1, le passage à l'état bas du signal S1 provoquant, après le délai $\tau_{LH2}$ (non référencé sur la figure 10), un passage à l'état haut (front montant référencé 416) du signal S2, le passage à l'état haut du signal S2 entraînant, après le délai $\tau_{LH3}$, un changement d'état du signal S3 (front montant référencé 418).

Les délais $\tau_{HL1}$ et $\tau_{LH2}$ peuvent être choisis inférieurs ou très inférieurs ou négligeables par rapport au délai $\tau_{LH3}$.

A un instant t5, le signal Scomp en sortie du comparateur 160, se trouve dans le premier état ou à l'état « stable » ou à l'état haut, tandis que le signal S3 émis sur l'entrée 173 « Set » de la bascule 171 passe à un état haut. Ce passage provoque un effet mémoire ou de mémorisation. Le signal S0 en sortie de la bascule reste le même ou ne change pas, tant que le signal Scomp en sortie du comparateur 160 ne change pas d'état. L'injecteur 190 reste dans son premier état de fonctionnement tant que le signal Scomp ne change pas d'état. Le bloc de commande 170 effectue ainsi une mise en veille ou une mise en attente de l'injecteur 190 ou un placement de l'injecteur 190 dans un état dans lequel il ne peut effectuer d'injection de charge tant que le Scomp reste à l'état stable. Lors de cette mise en veille, l'injecteur 190, peut être maintenu dans sa première phase de fonctionnement.

Entre un instant t5 à un instant t6 du chronogramme, le signal Vint (non représenté sur la figure 10) varie selon une ampleur donnée, en fonction d'une intensité lumineuse détectée par le détecteur 50.

Cette variation provoque à un instant t6, un changement d'état du signal Scomp (front descendant 420 sur la figure 10) en sortie du comparateur 160, ce qui permet de générer un nouveau front de commande de l'injecteur 190. Ce nouveau front de commande permet de déclencher une reprise du cycle de fonctionnement de l'injecteur 190. Le nouveau front de commande permet de provoquer une deuxième injection de charges (front descendant du signal Φ2 référencé 422) à un instant t7 ou à partir d'un instant t7. Ledit deuxième cycle de l'injecteur 190 se termine ensuite à un instant t8 (front montant référencé 424 du signal Φ1). Après la deuxième injection de charges, le bloc de commande 170 met en oeuvre une détection de l'état du signal Scomp. A un instant t9, le signal Scomp n'est pas revenu dans son état stable ou à l'état haut. Un autre nouveau front de commande est ensuite relancé. Cet autre nouveau front de commande permet de déclencher une reprise du cycle de fonctionnement de l'injecteur 190. Cet autre nouveau front de commande permet de provoquer une troisième injection de charges (front descendant référencé 428 du signal Φ2 sur la figure 10) à un instant t10 ou à partir d'un instant t10.

A un instant t11, comme le suggère un front montant référencé 430, la troisième injection de charges a permis de provoquer un retour à l'état stable du signal Scomp.

Selon une variante de mise en oeuvre du bloc de commande 170, ce dernier peut être sous forme d'un oscillateur activé par le signal Scomp. Cet oscillateur peut être mis en oeuvre pour que, après un passage du signal Scomp du premier état au deuxième état et tant que le signal Scomp en sortie du comparateur 160 se trouve dans le deuxième état, par exemple à l'état bas, l'oscillateur génère des fronts de commande, de manière à créer des signaux de phases Φ1 et Φ2 de commande de l'injecteur tels que décrits précédemment. L'oscillateur peut être également mis en oeuvre pour que, lorsque Scomp retrouve l'état stable ou passe du deuxième état au premier état, s'arrête de générer des fronts ou d'osciller. Un tel oscillateur peut être par exemple un multivibrateur astable.

**Revendications**

1. Dispositif microélectronique capteur d'image comprenant : au moins un détecteur formé d'au moins un élément photo-détecteur (50), au moins un condensateur d'intégration (110) associé au photodétecteur et apte à délivrer au moins un signal analogique (Vint) susceptible de varier au moins en fonction de quantités de photons reçues par le photodétecteur, un compteur (200) et des moyens de conversion analogique/numérique asynchrone comportant :

   - un comparateur (160) apte à recevoir un signal analogique (Vint) dudit condensateur d'intégration (110) et à délivrer un signal de sortie à deux états (Scomp) susceptible d'adopter, en fonction du signal analogique (Vint), un premier état dit « état stable » ou un deuxième état,
   - des moyens injecteurs (190) de charges aptes à modifier le signal analogique (Vint) par injection d'au moins une quantité de charges $Q_0$ dans ledit condensateur (110),
   - des moyens de commande (170) asynchrones des moyens injecteurs de charges (190), aptes à recevoir le signal à deux états (Scomp) et configurés pour commander les moyens injecteurs (190), le dispositif étant **caractérisé en ce que** les moyens de commande (170) comprennent :
   - des moyens (171, 178, 181, 184) pour identifier au moins un changement d'état du signal (Scomp) en sortie du comparateur (160), du premier état vers le deuxième état, le changement d'état permettant de générer un front de commande
   - des moyens (171, 178, 181, 184, 185) pour déclencher automatiquement et de manière asynchrone consécutivement à une identification de changement d'état par lesdits moyens pour identifier un changement d'état, plusieurs injections de charges $Q_0$ par les moyens injecteurs (190), les injections étant déclenchées par ledit front de commande et étant effectuées tant que le signal (Scomp) en sortie du comparateur (160) se maintient dans le deuxième état,

le moyens de conversion analogique/numérique étant aptes à délivrer un signal numérique au compteur (200) configuré pour effectuer un décompte d'un nombre d'injections effectuées par lesdits moyens injecteurs de charges pendant une période donnée à partir d'un signal de commande des moyens injecteurs, ce décompte étant destiné à donner une valeur numérique de charges issues du photo-détecteur.

2. Dispositif microélectronique capteur d'image selon la revendication 1, les quantités de charges injectées lors desdites injections de charges $Q_0$ étant fixes et égales entre elles.

3. Dispositif microélectronique capteur d'image selon la revendication 2, les moyens de commande étant aptes, lorsque le signal de sortie du comparateur (Scomp) se trouve dans le deuxième état juste après avoir été dans le premier état pendant une durée donnée, à commander un nombre de k, avec $k \geq 1$, injections de charges jusqu'à ce que le signal (Scomp) en sortie du comparateur (160) passe dans le premier état, le nombre k étant dépendant d'une ampleur de variation du signal analogique (Vint) pendant ladite durée donnée.

4. Dispositif microélectronique capteur d'image selon l'une des revendications 1 à 3, les moyens de commande des moyens injecteurs (190) de charge comprenant :

- des moyens formant au moins une bascule (171),
- des moyens (176, 177, 179, 180, 182, 183) formant une ou plusieurs cellules à retard (178, 181, 184),
- des moyens formant au moins une porte logique (185).

5. Dispositif microélectronique capteur d'image selon l'une des revendications 1 à 4, les moyens de commande des moyens injecteurs de charge comprenant un oscillateur commandé par le signal de sortie (Scomp) du comparateur.

6. Dispositif microélectronique capteur d'image selon l'une des revendications 1 à 5, dans lequel les moyens de commande (170) sont aptes à commander les moyens injecteurs (190), par l'intermédiaire d'au moins un premier signal de phase ($\Phi1$) et d'au moins un deuxième signal de phase ($\Phi2$), le premier signal de phase ($\Phi1$) et le deuxième signal de phase ($\Phi2$) étant des signaux à deux états.

7. Dispositif microélectronique capteur d'image selon la revendication 6, comprenant en outre : des moyens compteurs pour compter un nombre d'injections de charges effectuées par l'injecteur (190), à partir du premier signal de phase ($\Phi1$) ou/et du deuxième signal de phase ($\Phi2$).

8. Dispositif microélectronique capteur d'image selon l'une des revendications 1 à 7, l'élément photodétecteur et le convertisseur étant intégrés à un même pixel ou/et à une même puce ou/et appartenant à un même circuit intégré.

9. Dispositif microélectronique capteur d'image selon l'une des revendications 1 à 8, l'élément photo-détecteur étant apte à détecter au moins un rayonnement choisi parmi les rayonnements suivants : rayonnement infra-rouge, rayonnement X.

10. Procédé de commande d'un dispositif convertisseur analogique/numérique intégré à un capteur d'image et associé à un détecteur formé d'au moins un élément photo-détecteur (50), un dispositif convertisseur analogique/numérique asynchrone ou dépourvu d'horloge comportant :

- au moins un condensateur d'intégration (110) associé au photo-détecteur et apte à délivrer au moins un signal analogique (Vint) susceptible de varier au moins en fonction de la quantité de photons reçus par le photo-détecteur,
- un comparateur (160) apte à recevoir le signal analogique (Vint) dudit condensateur d'intégration (110) et à délivrer un signal de sortie à deux états (Scomp) susceptible d'adopter, en fonction du signal analogique (Vint), un premier état dit « état stable » ou un deuxième état,
- des moyens injecteurs (190) de charges aptes à modifier le signal analogique (Vint) par injection d'au moins une quantité charges (Qo) dans ledit condensateur (110),
- des moyens de commande asynchrones (170) des moyens injecteurs de charges (190), aptes à recevoir le signal à deux états (Scomp), le procédé étant **caractérisé en ce qu'**il comprend les étapes consistant à :
- identifier un changement d'état du signal en sortie du comparateur (Scomp) du premier état vers le deuxième état, le changement d'état permettant de générer un front de commande
- déclencher automatiquement et de manière asynchrone consécutivement audit changement d'état, plusieurs injections de charges les injections étant déclenchées par ledit front de commande et étant effectuées tant que le signal (Scomp) en sortie du comparateur (160) se maintient dans le deuxième état,
- effectuer un décompte d'un nombre d'injections effectuées par lesdits moyens injecteurs de charges pendant une période donnée à partir d'un signal de commande des moyens injecteurs, ce décompte étant destiné à donner une valeur numérique de charges issues du photo-détecteur.

11. Procédé de commande d'un convertisseur analogique/numérique selon la revendication 10, les quantités de charges (Qo) injectées lors desdites injections de charges étant fixes et égales entre elles.

12. Procédé de commande d'un convertisseur analogique/numérique selon l'une des revendications 10 ou 11, comprenant lorsque le signal de sortie du comparateur (Scomp) se trouve dans le deuxième état juste après avoir été dans le premier état pendant une durée donnée : le déclenchement d'un nombre k, avec k≥1 d'injections de charges jusqu'à ce que le signal à deux états (Scomp) change à nouveau d'état, le nombre k étant fonction d'une ampleur de variation du signal analogique (Vint) pendant ladite durée donnée.

13. Procédé de commande d'un convertisseur analogique/numérique selon l'une des revendications 10 à 12, comprenant en outre : une étape de comptage du nombre d'injections de charge effectuées par l'injecteur (190), par l'intermédiaire d'un premier signal de phase (Φ1) ou/et d'un deuxième signal de phase (Φ2), délivré(s) par les moyens de commande de l'injecteur (190).

14. Procédé de commande d'un convertisseur analogique/numérique selon l'une des revendications 10 à 13, l'élément photo-détecteur étant apte à détecter au moins un rayonnement choisi parmi les rayonnements suivants : rayonnement infra-rouge, rayonnement X.

**Patentansprüche**

1. Mikroelektronische Bildaufnahmevorrichtung, enthaltend:

zumindest einen Detektor, der aus zumindest einem Photodetektorelement (50) gebildet ist, zumindest einen Integrationskondensator (110), der dem Photodetektor zugeordnet und dazu geeignet ist, zumindest ein analoges Signal (Vint) auszugeben, das zumindest in Abhängigkeit von den Mengen an Photonen variieren kann, die von dem Photodetektor empfangen werden, einen Zähler (200) und Mittel zur asynchronen Analog-Digital-Umwandlung, enthaltend:

- einen Komparator (160), der dazu geeignet ist, ein analoges Signal (Vint) von dem Integrationskondensator (110) zu empfangen und ein Ausgangssignal mit zwei Zuständen (Scomp) auszugeben, das in Abhängigkeit von dem analogen Signal (Vint) einen ersten Zustand, "stabiler Zustand" genannt, oder einen zweiten Zustand annehmen kann,
- Einspeisemittel (190) zum Einspeisen von Ladungen, die dazu geeignet sind, das analoge Signal (Vint) durch Einspeisen von zumindest einer Ladungsmenge $Q_0$ in den Kondensator (110) zu ändern,
- asynchrone Steuermittel (170) zum Steuern der Ladungseinspeisemittel (190), die dazu geeignet sind, das Signal mit zwei Zuständen (Scomp) zu empfangen und dazu ausgelegt sind, die Einspeisemittel (190) zu steuern,

wobei die Vorrichtung **dadurch gekennzeichnet ist, dass** die Steuermittel (170) enthalten:

- Mittel (171, 178, 181, 184) zum Erkennen zumindest einer Zustandsänderung des Signals (Scomp) am Ausgang des Komparators (160) vom ersten Zustand in den zweiten Zustand, wobei die Zustandsänderung gestattet, eine Steuerflanke zu erzeugen,
- Mittel (171, 178, 181, 184, 185), um auf eine Erkennung der Zustandsänderung durch die genannten Mittel zum Erkennen einer Zustandsänderung folgend mehrere Ladungseinspeisungen $Q_0$ durch die Einspeisemittel (190) automatisch und asynchron auszulösen, wobei die Einspeisungen durch die Steuerflanke ausgelöst und solange durchgeführt werden, wie das Signal (Scomp) am Ausgang des Komparators (160) sich in dem zweiten Zustand hält,

wobei die Mittel zur Analog-Digital-Umwandlung dazu geeignet sind, ein digitales Signal an den Zähler (200) auszugeben, der dazu ausgelegt ist, einen Zählvorgang einer Anzahl von durch die Ladungseinspeisemittel während eines gegebenen Zeitraums erfolgten Einspeisungen ab einem Steuersignal zum Steuern der Einspeisemittel durchzuführen, wobei dieser Zählvorgang dazu bestimmt ist, einen digitalen Wert von von dem Photodetektor stammenden Ladungen zu ergeben.

**2.** Mikroelektronische Bildaufnahmevorrichtung nach Anspruch 1, wobei die Mengen an Ladungen, die bei den Ladungseinspeisungen $Q_0$ eingespeist werden, fest und zueinander gleich sind.

**3.** Mikroelektronische Bildaufnahmevorrichtung nach Anspruch 2, wobei die Steuermittel dazu geeignet sind, dann, wenn das Ausgangssignal des Komparators (Scomp) sich in dem zweiten Zustand befindet, gerade nachdem es für eine gegebene Zeitdauer in dem ersten Zustand war, eine Anzahl von k Ladungseinspeisungen, mit $k \geq 1$, zu steuern, bis das Signal (Scomp) am Ausgang des Komparators (160) in den ersten Zustand übergeht, wobei die Anzahl k von einem Änderungsausmaß des analogen Signals (Vint) während der gegebenen Zeitdauer abhängt.

**4.** Mikroelektronische Bildaufnahmevorrichtung nach einem der Ansprüche 1 bis 3, wobei die Steuermittel zum Steuern der Ladungseinspeisemittel (190) enthalten:

- Mittel, die zumindest ein Flipflop (171) bilden,
- Mittel (176, 177, 179, 180, 182, 183), die eine oder mehrere Verzögerungszellen (178, 181, 184) bilden,
- Mittel, die zumindest ein Logikgatter (185) bilden.

**5.** Mikroelektronische Bildaufnahmevorrichtung nach einem der Ansprüche 1 bis 4, wobei die Steuermittel zum Steuern der Ladungseinspeisemittel einen Oszillator enthalten, der über das Ausgangssignal (Scomp) des Komparators gesteuert wird.

**6.** Mikroelektronische Bildaufnahmevorrichtung nach einem der Ansprüche 1 bis 5, wobei die Steuermittel (170) dazu geeignet sind, die Einspeisemittel (190) über zumindest ein erstes Phasensignal ($\phi$1) und zumindest ein zweites Phasensignal ($\phi$2) zu steuern, wobei das erste Phasensignal ($\phi$1) und das zweite Phasensignal ($\phi$2) Signale mit zwei Zuständen sind.

**7.** Mikroelektronische Bildaufnahmevorrichtung nach Anspruch 6, ferner enthaltend:

Zählmittel zum Zählen einer Anzahl von Ladungseinspeisungen, die von dem Einspeisemittel (190) durchgeführt werden, und zwar ab dem ersten Phasensignal ($\phi$1) und/oder dem zweiten Phasensignal ($\phi$2).

**8.** Mikroelektronische Bildaufnahmevorrichtung nach einem der Ansprüche 1 bis 7, wobei das Photodetektorelement und der Wandler in einem gleichen Pixel und/oder einem gleichen Chip integriert sind und/oder zu einer gleichen integrierten Schaltung gehören.

**9.** Mikroelektronische Bildaufnahmevorrichtung nach einem der Ansprüche 1 bis 8, wobei das Photodetektorelement dazu geeignet ist, zumindest eine Strahlung zu detektieren, ausgewählt aus den nachfolgenden Strahlungen: Infrarotstrahlung, Röntgenstrahlung.

**10.** Verfahren zum Steuern einer Analog-Digital-Wandlervorrichtung, die einem Bildsensor integriert und einem Detektor zugeordnet ist, der aus zumindest einem Photodetektorelement (50) gebildet ist, wobei eine asynchrone bzw. taktschaltungslose Analog-Digital-Wandlervorrichtung enthält:

- zumindest einen Integrationskondensator (110), der dem Photodetektor zugeordnet und dazu geeignet ist, zumindest ein analoges Signal (Vint) auszugeben, das zumindest in Abhängigkeit von der Menge an Photonen variieren kann, die von dem Photodetektor empfangen werden,
- einen Komparator (160), der dazu geeignet ist, ein analoges Signal (Vint) von dem Integrationskondensator (110) zu empfangen und ein Ausgangssignal mit zwei Zuständen (Scomp) auszugeben, das in Abhängigkeit von dem analogen Signal (Vint) einen ersten Zustand, "stabiler Zustand" genannt, oder einen zweiten Zustand annehmen kann,
- Einspeisemittel (190) zum Einspeisen von Ladungen, die dazu geeignet sind, das analoge Signal (Vint) durch Einspeisen von zumindest einer Ladungsmenge ($Q_0$) in den Kondensator (110) zu ändern,
- asynchrone Steuermittel (170) zum Steuern der Ladungseinspeisemittel (190), die dazu geeignet sind, das Signal mit zwei Zuständen (Scomp) zu empfangen, wobei das Verfahren **dadurch gekennzeichnet ist, dass** es die nachfolgenden Schritte umfasst:
- Erkennen einer Zustandsänderung des Signals (Scomp) am Ausgang des Komparators vom ersten Zustand in den zweiten Zustand, wobei die Zustandsänderung gestattet, eine Steuerflanke zu erzeugen,
- auf eine Zustandsänderung folgend automatisches und asynchrones Auslösen von mehreren Ladungseinspeisungen, wobei die Einspeisungen durch die Steuerflanke ausgelöst und solange durchgeführt werden, wie das Signal (Scomp) am Ausgang des Komparators (160) sich in dem zweiten Zustand hält,
- Durchführen eines Zählvorgangs einer Anzahl von durch die Ladungseinspeisemittel während eines gegebenen Zeitraums erfolgten Einspeisungen ab einem Steuersignal zum Steuern der Einspeisemittel, wobei dieser Zählvorgang dazu bestimmt ist, einen digitalen Wert von von dem Photodetektor stammenden Ladungen zu ergeben.

11. Verfahren zum Steuern eines Analog-Digital-Wandlers nach Anspruch 10, wobei die bei den Ladungseinspeisungen eingespeisten Ladungsmengen ($Q_0$) fest und zueinander gleich sind.

12. Verfahren zum Steuern eines Analog-Digital-Wandlers nach einem der Ansprüche 10 oder 11, umfassend dann, wenn das Ausgangssignal des Komparators (Scomp) sich in dem zweiten Zustand befindet, gerade nachdem es für eine gegebene Zeitdauer in dem ersten Zustand war, das Auslösen einer Anzahl von k Ladungseinspeisungen, mit $k \geq 1$, bis das Signal mit zwei Zuständen (Scomp) erneut seinen Zustand ändert, wobei die Anzahl k Funktion von einem Änderungsausmaß des analogen Signals (Vint) während der gegebenen Zeitdauer ist.

13. Verfahren zum Steuern eines Analog-Digital-Wandlers nach einem der Ansprüche 10 bis 12, ferner umfassend: einen Schritt des Zählens der Anzahl von Ladungseinspeisungen, die von dem Einspeisemittel (190) über ein erstes Phasensignal ($\phi$1) und/oder ein zweites Phasensignal ($\phi$2) durchgeführt werden, das bzw. die von den Steuermitteln zum Steuern des Einspeisemittels (190) ausgegeben wird bzw. werden.

14. Verfahren zum Steuern eines Analog-Digital-Wandlers nach einem der Ansprüche 10 bis 13, wobei das Photodetektorelement dazu geeignet ist, zumindest eine Strahlung zu detektieren, ausgewählt aus den nachfolgenden Strahlungen: Infrarotstrahlung, Röntgenstrahlung.

**Claims**

1. Image sensing microelectronic device comprising: at least one detector formed of at least one photodetector element (50), at least one integration capacitor (110) associated with the photodetector and capable of delivering at least one analog signal (Vint) able to vary at least in relation to quantities of photons received by the photodetector, a counter (200) and asynchronous analog/digital conversion means comprising:

   - a comparator (160) able to receive an analog signal (Vint) from said integration capacitor (110) and to deliver a two-statess output signal (Scomp) which, in relation to the analog signal (Vint), is able to be in a first state called "stable state" or in a second state,

   - charge injector means (190) able to modify the analog signal (Vint) by injecting at least a quantity of charges (Qo) into said capacitor (110),
   - asynchronous command means (170) commanding the charge injector means (190), able to receive the two-states signal (Scomp) and configured for commanding the injector means (190), the device being **characterized in that** command means (170) comprise:

      • means (171, 178, 181, 184) to identify at least a state change of the signal (Scomp) output by the comparator (160), from the first state to the second state, the state change allowing to generate a command edge,
      • means (171, 178, 181, 184, 185) to trigger automatically and asynchronously, consecutively of an identification of a state change by said means to identify a change of the state, several consecutive charge injections $Q_0$ by the injector means (190), injections being triggered by said command edge and executed as long as the output signal (Scomp) leaving the comparator (160) is held in the second state,

   analog/digital converting means able to deliver a digital signal to said counter (200) configured to count a number of injections performed by said charge injector means during a given period from a control signal of the charge injector means, this count being intended to give a numerical value of charges from the photodetector.

2. Image sensing microelectronic device according to claim 1, the quantities of charges injected during said charge injections $Q_0$ being fixed and equal to each other.

3. Image sensing microelectronic device according to claim 2, the command means being capable, when the output signal of the comparator (Scomp) lies in the second state just after having been in the first state for a given time, of commanding a number k, where $k \geq 1$, of charge injections until the output signal (Scomp) from the comparator (160) enters the first state, the number k being dependent on a variation amplitude of the analog signal (Vint) during said given time.

4. Image sensing microelectronic device according to any of claims 1 to 3, the command means of the charge injector means (190) comprising:

   - means forming at least one trigger (171),
   - means (176, 177, 179, 180, 182, 183) forming one or more delay cells (178, 181, 184),

- means forming at least one logic gate (185)

5. Image sensing microelectronic device according to any of claims 1 to 4, the command means of the charge injector means comprising an oscillator commanded by the output signal (Scomp) of the comparator.

6. Image sensing microelectronic device according to any of claims 1 to 5, wherein the command means (170) are able to command the injector means (190), via at least one first phase signal (Φ1) and at least one second phase signal (Φ2), the first phase signal (Φ1) and the second phase signal (Φ2) being two-statess signals.

7. Image sensing microelectronic device according to claim 6, also comprising: counting means, for counting a number of charge injections performed by the injector (190), from the first phase signal (Φ1) or/and from the second phase signal (Φ2).

8. Image sensing microelectronic device according to any of claims 1 to 7, the photodetector element and the converter being integrated in one same pixel or/and one same chip or/and belonging to one same integrated circuit.

9. Image sensing microelectronic device according to any of claims 1 to 8, the photodetector element being able to detect at least one radiation chosen from among the following radiations: infrared radiation, X-radiation.

10. Method to command an analog/digital converter device integrated in an image sensor and associated with a detector formed of at least one photodetector element (50), an asynchronous or clock-free analog/digital converter device comprising:

- at least one integration capacitor (110) associated with the photodetector and capable of delivering at least one analogue signal which may vary at least as a function of the quantity of photons received by the photodetector,
- a comparator (160) able to receive the analog signal (Vint) from said integration capacitor (110) and to deliver a two-statess output signal (Scomp) which, in relation to the analog signal (Vint), is able to take a first state called "stable state" or a second state,
- charge injector means (190) able to modify the analog signal (Vint) by injecting at least one quantity of charges (Qo) into said capacitor (110),
- asynchronous command means (170) commanding the charge injector means (190), able to receive the two-states signal (Scomp), the method being **characterized in that** it comprises the steps consisting of:

• identifying state change of the comparator output signal (Scomp) from the first state to the second state, the state change allowing to generate a command edge,
• triggering automatically and asynchronously, consecutively to said change of the state, several consecutive charge injections, injections being triggered by said command edge and executed as long as the output signal (Scomp) from the comparator (160) is held in the second state

performing a count of a number of injections performed by said charge injecting means during a given period from a control signal of the injector means, said count being intended to give a numerical value of charges originating from the photodetector.

11. Method to command an analog/digital converter according to claim 10, the quantities of charges (Qo) injected during said charge injections being fixed and equal to each other

12. Method to command an analog/digital converter according to either of claims 10 or 11, comprising when the comparator output signal (Scomp) lies in the second state just after having been in the first state for a given time, it comprises: the triggering of a number k of charge injections, in which k ≥ 1, until the two-statess signal (Scomp) again changes state, the number k being related to a variation amplitude of the analog signal (Vint) during said given time.

13. Method to command an analog/digital converter according to any of claims 10 to 12, also comprising: a counting step to count the number of charge injections performed by the injector (190), via a first phase signal (Φ1) or/and a second phase signal (Φ2) delivered by the command means of the injector (190) .

14. Method to command an analog/digital converter according to any of claims 10 to 13, the photodetector element being capable of detecting at least one radiation chosen from among the following radiations: infrared radiation, X-radiation.

**FIG. 1**

**FIG. 2**

FIG. 3

FIG. 4

FIG. 5

FIG. 6

## FIG. 7

## FIG. 8

FIG. 9

FIG. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 5461425 A

**Littérature non-brevet citée dans la description**

• **ERIC R. FOSSUM.** Approaches and Analysis for on Focal Plane Analog to Digital Conversion. SPIE, 1994, vol. 2226

• A Low Power Low-Noise Ultrawide-Dynamic Range CMOS Imager With Pixel-Parallel A/D Conversion. **L. G. MCLLRATH.** JSSCC. IEEE, Mai 2001, vol. 36